# EUROPÄISCHE PATENTANMELDUNG

(11) **EP 1 648 211 A2**
(43) Veröffentlichungstag der Anmeldung: **19.04.2006**
(21) Anmeldenummer: 06001191.3
(22) Anmeldetag: 26.11.2001
(51) Int. Cl.: H05K 5/00

(54) **Medizingerät mit partiell transparentem Gehäuse und dessen Verwendung**

(30) Priorität: 28.11.2000 DE 10059068
(62) Teilanmeldung aus: 01994720.9
(71) Anmelder: 3M ESPE AG, 82229 Seefeld (DE)
(72) Erfinder: Keller, Michael, 82131 Gauting (DE); Pauser, Helmut, 86911 Diessen (DE); Hartung, Martin, Dr., 82205 Gilching (DE)

(57) **Zusammenfassung**

Die Erfindung betrifft die Verwendung einer Vorrichtung umfassend ein Gehäuse mit einer Gehäusewand aus einem nichttransparenten Kunststoff und eine Anzeigeeinheit mit mindestens einem im Bereich von 400 bis 700 nm Licht emittierenden Element das sich innerhalb des Gehäuses unterhalb der Innenoberfläche der Gehäusewand befindet, wobei die Gehäusewand im Bereich des lichtemittierenden Elements mindestens eine Vertiefung auf der Innenseite der Gehäusewand aber keine Durchbrüche aufweist, im Medizinbereich zur Anzeige des Ladezustands von Batterien, Informationen über die abgegebene Lichtintensität, den Einschaltzustand, die Betriebsart oder Fehlermeldungen eines batteriebetriebenen Belichtungsgeräts.

## Beschreibung

Die Erfindung betrifft eine Vorrichtung, umfassend ein Gehäuse und eine Anzeigeeinheit, die durch die Gehäusewand hindurch optisch wahrnehmbar ist. Bei der Vorrichtung handelt es sich vorzugsweise um ein Medizingerät.

Bekannt sind beleuchtbare Schalter mit einem Gehäuse, wie sie in der US-4,778,967 beschrieben sind. Ein beleuchtbares Bedienungselement wie eine Taste, das eine Aufnahme aus transparentem Material aufweist und als Lichtleiter fungiert ist, aus der DE 37 15 528 C2 bekannt.

Aus dem Stand der Technik sind auch Vorrichtungen bekannt, umfassend ein Gehäuse und eine Anzeigeeinheit mit lichtemittierenden Elementen, wobei die lichtemittierenden Elemente üblicherweise durch ein Fenster, das in eine Aussparung der Gehäusewand eingesetzt ist, optisch wahrnehmbar sind.

Solche Geräte sind insbesondere auf dem Medizinsektor üblich, wenn es gilt, Informationen optisch wahrnehmbar zu machen.

Nachteilig an solchen Geräten ist, dass, bedingt durch das in die Gehäusewand eingearbeitete Fenster, in der Gehäusewand Spalten, Ritze oder Vertiefungen vorhanden sind, die leicht verschmutzen, aber nur sehr aufwendig zu reinigen, insbesondere zu desinfizieren sind.

Hinzu kommt, dass diese Vorrichtungen, bedingt durch die größere Anzahl von Teilen, verhältnismäßig aufwendig zu fertigen sind und damit bei der Herstellung höhere Kosten anfallen.

Folglich ist es eine Aufgabe der vorliegenden Erfindung, eine Vorrichtung bereitzustellen, die diese Probleme vermeidet.

Eine weitere Aufgabe kann darin gesehen werden, eine Vorrichtung bereitzustellen, die die Detektion von Gegenständen ermöglicht, die sich in der Nähe der Vorrichtung befinden.

Diese Aufgabe wird mit einer Vorrichtung gelöst, wie sie in den Ansprüchen beschrieben ist.

Mit den Begriffen "umfassen" oder "enthalten" wird eine nicht abschließende Aufzählung von Merkmalen eingeleitet. Der Umstand, dass in den Ansprüchen das Wort "ein" vor Nennung eines Merkmals verwendet wird, schließt nicht aus, dass die genannten Merkmale mehrmals vorhanden sein können, im Sinne von "mindestens ein".

Die Erfindung weist folgende Vorteile auf:

Die erfindungsgemäße Vorrichtung lässt sich einfach und effektiv reinigen, da die Vorrichtung im Bereich der Anzeigeeinheit keine Ausnehmungen zur Einarbeitung eines Fensters aufweisen muss, damit die lichtemittierenden Elemente optisch wahrnehmbar sind.

Bedingt durch eine weitgehend einheitlich durchgehende Oberfläche des Gehäuses der Vorrichtung ist der Fertigungsaufwand reduziert, da in das Gehäuse keine Ausschnitte eingearbeitet zu werden brauchen.

Unter Gehäuse im Sinne der vorliegenden Erfindung ist jegliche äußere Umhüllung einer Vorrichtung zu verstehen, die irgendeine lichtemittierende Anzeigeeinheit aufweist. Das Gehäuse kann aus nur einem Teil gefertigt und aus einem einheitlichen Material bestehen, kann aber auch aus unterschiedlichen Elementen, die ihrerseits unterschiedlichen Materialien enthalten, zusammengesetzt sein.

Primäre Aufgabe des Gehäuses ist es, die sich im Gehäuse befindlichen Bauteile vor äußeren, insbesondere mechanischen Einflüssen, zu schützen. Das Gehäuse ist diesbezüglich vorzugsweise aus einem bruchfesten Material gefertigt. Das Gehäuse ist vorzugsweise auch weitgehend gekapselt und weist bis auf notwendige Durchbrüche in Form von Lüftungsschlitzen oder Durchbrüchen für Kabel keine Öffnungen auf.

Vorzugsweise ist die Gehäusewand aus einem einheitlichen Material gefertigt. Die Gehäusewand weist überwiegend die gleiche Stärke auf. Üblich sind Gehäusewandstärken im Bereich von 1 bis 5, vorzugsweise von 2 bis 3 mm.

Der Begriff nichttransparent umfasst Materialien, die, wenn gegen eine dunkle Oberfläche gehalten, es nicht erlauben bei normaler Beleuchtungsstärke, diese Oberfläche optisch, vorzugsweise mit dem menschlichen Auge oder einem optischen Sensor, beispielsweise einer Photozelle, durch das Material hindurch wahrzunehmen. Nicht umfasst sind somit durchsichtige Materialien wie Acrylglas .

Unter Anzeigeeinheit sind elektrisch betreibbare Bestandteile einer Vorrichtungen zu verstehen, die über irgendeinen Betriebszustand der Vorrichtung optisch eine Information wiedergibt. Solche Informationen können beispielsweise sein der Ladezustand der Batterien einer batteriebetriebenen Vorrichtung, Informationen über die abgegebene Lichtintensität einer Beleuchtungsvorrichtung, den Einschaltzustand, die Betriebsart, Fehlermeldungen.

Der Begriff lichtemittierende Elemente umfasst alle Elemente, die, wenn mit elektrischem Strom betrieben, Licht emittieren können, wie Glühlampen, lichtemittierende Dioden (LED), 7-Segment-Anzeigen und/oder Laserdioden.

Die von den lichtemittierenden Elementen ausgesendete Strahlung liegt im Bereich von 400 bis 1300 nm. Für die Anwendung als Anzeige haben sich Wellenlängen im Bereich von 400 bis 700 nm bewährt, für die Anwendung zur Detektion von Gegenständen Wellenlängen im Bereich von 600 bis 1300 nm.

Die Strahlungsleistung liegt beispielsweise im Bereich von 0,1 bis 30 mW, vorzugsweise im Bereich von 1 bis 10 mW.

Die erfindungsgemäße Vorrichtung weist mindestens ein lichtemittierendes Element, vorzugsweise zwei, drei oder mehr lichtemittierende Elemente auf.

Optisch wahrnehmbar im Sinne der Erfindung heißt, dass vorzugsweise mit dem menschlichen Auge erkennbar ist, ob ein lichtemittierendes Element bei üblicher künstlicher oder natürlicher Beleuchtung Licht abstrahlt oder nicht. In Abhängigkeit der gewünschten Ausführungsform können aber auch Strahlungssensoren wie Photozellen, Photodioden oder Phototransistoren zur optischen Wahrnehmung eingesetzt werden.

Das Vorhandensein eines lichtemittierenden Elements ist im nicht-emittierenden Zustand von außen nicht erkennbar, wohingegen im emittierenden Zustand die Emission des lichtemittierenden Elements von außen durch die Gehäusewand in einem weitgehend scharf abgrenzbaren Bereich optisch wahrnehmbar ist. Zu unterscheiden hiervon ist eine diffuse, einem abgrenzbaren Bereich nicht klar zuordenbare Emission, wie sie beispielsweise bei von innen illuminierbaren Schaltern bekannt ist.

Naturgemäß weist die Vorrichtung auch eine Schalteinheit auf, über die die Vorrichtung beispielsweise in den Betriebszustand gesetzt werden kann. Die Schalteinheit kann als Netzschalter, Umschalter und/oder Einschalter ausgebildet sein. Die Schalteinheit hat üblicherweise die Form eines Druckknopfes, eines Kipp- oder Drehschalters. Üblicherweise weist das Gehäuse an dieser Stelle eine Ausnehmung auf.

Die optische Wahrnehmbarkeit der lichtemittierenden Elemente wird durch die Gehäusewand hindurch durch Reduzierung der Wandstärke der Gehäusewand, vorzugsweise auf der Gehäuseinnenseite, erreicht. Dies führt zu einer Reduzierung der Schichtdicke der Gehäusewand (Vertiefung) und damit zu einer Erhöhung der Transparenz an dieser Stelle.

Eine Vertiefung im Sinne der Erfindung liegt dann vor, wenn die Schichtdicke der Gehäusewand an dieser Stelle im Vergleich zur üblichen Schichtdicke der Gehäusewand geringer ist. Eine Reduzierung um mindestens 50%, vorzugsweise im Bereich von 60 bis 90% hat sich als vorteilhaft erwiesen. Die Gehäusewand ist in diesem Bereich beispielsweise nur etwa 0,2 bis 0,8 mm, vorzugsweise 0,3 bis 0,6 mm stark.

Unter den Begriff Vertiefung fallen somit Einkerbungen, Bohrungen, Ritze und Materialdefizite insbesondere auf der Innenseite der Gehäusewand, die nicht bis zur Außenoberfläche der Gehäusewand durchdringen. Im Gegensatz dazu sind unter Durchbrüchen im Sinne der Erfindung Materialdefizite zu verstehen, die von der Innenfläche bis zur Außenfläche der Gehäusewand reichen, beispielsweise Fenster oder Bohrungen.

Die Vertiefung erfolgt vorzugsweise nur in den Bereichen, in denen sich lichtemittierende Elemente befinden und vorzugsweise in der Form, dass die lichtemittierenden Elemente in die Vertiefung eingebracht bzw. eingepasst werden können.

Kreisförmige Vertiefungen in Form einer Bohrung haben sich bei Verwendung von LEDs als lichtemittierende Elemente als günstig erwiesen. Der Durchmesser der Bohrungen ist üblicherweise etwas größer als der Durchmesser des lichtemittierenden Elements und liegt normalerweise im Bereich von 2 bis 6 mm, vorzugsweise 3 bis 5 mm.

Der Abstand der lichtemittierenden Elemente von der Innenoberfläche der Gehäusewand in der Vertiefung ist grundsätzlich beliebig, ein geringer Abstand ist aber vorzuziehen. Die Wahrnehmung der lichtemittierenden Elemente im emittierenden Zustand durch die Gehäusewand ist besonders gut lokalisierbar, wenn der Abstand des lichtemittierenden Elements von der Innenoberfläche der Gehäusewand in der Vertiefung im Bereich von 0,5 bis 2 mm, vorzugsweise im Bereich von 0,7 bis 1 mm liegt.

Die erfindungsgemäße Vorrichtung weist auf der Außenoberfläche, zumindest im Bereich der Anzeigeeinheit, keine Vertiefungen, Ausnehmungen und/oder Durchbrüche auf. Auf diese Weise ist eine einheitlich glatte Oberfläche sichergestellt, die sich leicht reinigen lässt.

Geeignete Materialien für ein Gehäuse der erfindungsgemäßen Vorrichtungen umfassen insbesondere Kunststoffe, wie Polystyrol (PS), Polycarbonat (PC), Acrylnitrilbutadienstyrol (ABS), Polybutylenterephthalat (PBTP), Styrol-Acrylnitril (SAN), Polyamid (PA), Polyoxymethylen (POM), Polyphenylenoxid (PPO), PE, PP, PTFE und Homo- und Copolymere dieser Kunststoffe.

Die Kunststoffe können auch gefüllt oder faserverstärkt eingesetzt werden. Je nach Anwendungsgebiet können die Kunststoffe auch oberflächenbeschichtet sein, beispielsweise mit Lacken.

Möglich ist auch der Einsatz von farbigen, beispielsweise mit Pigmenten eingefärbten Kunststoffen.

Um die optische Wahrnehmbarkeit der lichtemittierenden Elemente durch farbige Materialien sicherzustellen, ist entweder die Lichtleistung der lichtemittierenden Elemente zu erhöhen oder die Wandstärke der Gehäusewand zumindest im Bereich der Anzeigeeinheit zu erniedrigen.

Das Herstellungsverfahren für das Gehäuse der erfindungsgemäßen Vorrichtung richtet sich nach den verwendeten Materialien.

Das Gehäuse der erfindungsgemäßen Vorrichtung wird vorzugsweise durch Spritzgießen hergestellt. Eine spangebende Herstellung, wie durch Fräsen aus einem Formkörper, ist aber auch denkbar und möglich.

Die erfindungsgemäßen Vorrichtungen lassen sich in allen Bereichen einsetzen, in denen eine einheitliche, insbesondere leicht zu reinigende Oberfläche wünschenswert ist.

Vorzugsweise werden die erfindungsgemäßen Vorrichtungen im Medizinbereich eingesetzt. In diesem Bereich ist es oftmals von eminenter Wichtigkeit, dass sich die Vorrichtungen leicht und effektiv reinigen, gegebenenfalls desinfizieren lassen.

Beispielhaft für derartige Vorrichtungen seien genannt: Belichtungsgeräte, Mischgeräte, insbesondere Geräte, die im dentalen Bereich Anwendung finden.

Die Vorrichtung kann auch dazu verwendet werden, um das Vorhandensein, Fehlen oder die Identifizierung eines Gegenstandes, der sich in vergleichsweise naher Entfernung im Bereich der die Vertiefung aufweisenden Gehäusewand befindet, zu detektieren.

Hierzu weist die Gehäusewand der Vorrichtung vorzugsweise im wesentlichen benachbart zur ersten Vertiefung eine weitere Vertiefung auf, in der sich ein zur Detektion von elektromagnetischer Strahlung geeignetes Element befindet. Des weiteren ist der Gegenstand vorzugsweise auf seiner Außenoberfläche derart auszubilden, dass er das von dem lichtemittierenden Element durch die Gehäusewand gestrahlte Licht in geeigneter Weise zu reflektieren vermag.

Erfahrungsgemäß funktioniert die Detektion des Vorhandenseins oder Fehlens des Gegenstandes um so besser, je näher der Gegenstand sich an der Gehäusewand der Vorrichtung befindet. Brauchbare Entfernung liegen im Bereich von 0,01 bis 3 cm, vorzugsweise von 0,5 bis 10 mm.

Der Gegenstand seinerseits muss ansonsten nicht näher individualisiert sein.

Geeignete Elemente sind insbesondere reflektierende Oberflächen, spiegelnd reflektierende aber auch diffus streuende Materialien.

Das Problem, das Vorhandenseins oder Fehlen von Gegenständen zu ermitteln bzw. deren Beschaffenheit zu identifizieren ist grundsätzlich bekannt. Diesbezüglich wird auf die WO-00/38841 oder die EP 0 699 582 A1 verwiesen. Im Unterschied zu den dort vorgeschlagenen Lösungen zeichnet sich die vorliegende Erfindung dadurch aus, dass das Erkennungssystem vergleichsweise einfach aufgebaut ist und bedingt durch die Anordnung der elektrischen Bauteile hinter einer Gehäusewand, die zumindest in diesem Bereich keine Durchbrüche aufweist, sehr einfach zu reinigen ist, sollte dies erforderlich sein.

In einer besonderen Ausführungsform handelt es sich bei der Vorrichtung um ein Mischgerät, insbesondere zum Mischen von dentalen Abformmassen, wie es beispielsweise in der EP 0 492 413 B1 beschrieben ist. Bei den zu detektierenden Gegenständen handelt es sich in diesem Fall vorzugsweise um in das Mischgerät einzulegende Behältnisse bzw. Kartuschen, wie sie beispielsweise in der EP 0787655 A2 beschrieben sind.

Sobald eine Kartusche in das Mischgerät eingelegt wird, kann die Art des Behältnisses und die in dieses abgefüllte Masse vom Mischgerät auf einfache Weise bestimmt und das Mischgerät in Abhängigkeit von dem eingelegten Behältnis gesteuert werden. Auf diese Weise kann auch verhindert werden, dass in das Mischgerät ungeeignete Behältnisse eingelegt werden, die bei Betrieb des Mischgeräts zu dessen Beschädigung führen können.

Die oben genannte Vorrichtung, insbesondere in Form eines Mischgerät, weist somit im Bereich der Aufnahme für die einzulegenden Behältnisse einen Sender und einen Empfänger auf, die sich jeweils in Vertiefungen der Gehäusewand befinden. Das vom Sender ausgesandte Licht wird von dem einzulegenden Behältnis, in Abhängigkeit der Beschaffenheit der Oberfläche des Behältnisses mehr oder weniger reflektiert. Das reflektierte Licht wird vom Empfänger detektiert und erzeugt dort ein Signal. Im einfachsten Fall weist das zu detektierende Behältnis auf der Oberfläche eine hell/dunkel-Schattierung, beispielsweise in Form eines Strichcodes auf, der auf einfache Weise mittels eines Tintenstrahldruckers während der Fertigung des Behältnisses oder Teilen davon aufgebracht werden kann.

Durch Anbringen von gegebenenfalls mehreren Sendern und/oder mehreren Empfängern kann auf diese Weise nicht nur das Vorhandensein oder Fehlen des Behältnisses detektiert, sondern zusätzliche Information über das Behältnis bzw. die sich darin befindende Masse übermittelt werden.

Die beschriebene Ausführungsform zeichnet sich somit durch eine Reihe von Vorteilen aus, wie einfacher Aufbau des Erkennungssystems aus Sende- und Leseinheit unter Verwendung billiger Bauteile, preiswertes Aufbringen einer Codierung auf ein Behältnis und Erleichterung der Reinigung der Sende- und Leseeinheit bei Verschmutzung, da die Vorrichtung zumindest in diesem Bereich keine Durchbrüche aufweist.

Bevorzugte Ausführungsbeispiele werden nachstehend anhand der Zeichnungen erläutert.
Figur 1 zeigt einen Ausschnitt einer möglichen Ausführungsform der Vorrichtung im Querschnitt.

Figur 2 zeigt eine konkrete Anwendungsform für ein Gehäuse mit einem partiell transparentem Gehäuse.

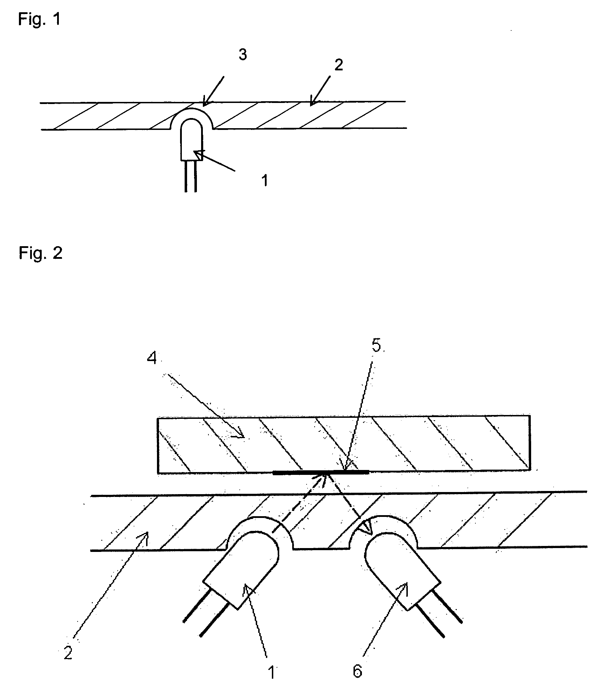

Die erfindungsgemäße Vorrichtung gemäß Figur 1 umfasst ein lichtemittierendes Element (1), beispielsweise eine LED, und eine Gehäusewand (2), die im Bereich (3), in dem das lichtemittierende Element angeordnet ist, auf der Innenseite eine Vertiefung aufweist. Das lichtemittierende Element ist vorliegend teilweise in diese Vertiefung eingelassen.
In Figur 2 befindet sich gegenüber dem lichtemittierendem Element (1) ein Gegenstand (4), mit beispielsweise einem reflektierenden Oberflächenbereich (5), der das von dem lichtemittierenden Element (1) durch die Gehäusewand (2) gestrahlte Licht reflektiert und auf die Gehäusewand (2) reflektiert. Dort kann es durch ein zur optischen Wahrnehmung geeignetes Element (6), beispielsweise eine Photozelle, Photodiode oder ein Phototransistor, welches in eine Vertiefung eingelassen ist, detektiert werden. Auf diese Weise eignet sich die Vorrichtung zur Erfassung des Vorhandenseins oder Fehlens eines Gegenstands, der sich in vergleichsweise naher Entfernung vor der Gehäusewand befindet.

## Patentansprüche

1. Verwendung einer Vorrichtung, umfassend ein Gehäuse mit einer Gehäusewand aus einem nichttransparenten Kunststoff mit einer Außen- und einer Innenoberfläche, wobei die Stärke der Gehäusewand im Bereich von 1 bis 5 mm liegt, und eine Anzeigeeinheit, mit mindestens einem im Bereich von 400 bis 700 nm Licht emittierenden Element, das sich innerhalb des Gehäuses unterhalb der Innenoberfläche der Gehäusewand befindet, wobei die Gehäusewand im Bereich des lichtemittierenden Elements mindestens eine Vertiefung auf der Innenseite der Gehäusewand aber keine Durchbrüche aufweist und wobei die Leuchtstärke des mindestens einen lichtemittierenden Elements so abgestimmt ist, dass das mindestens eine lichtemittierende Element im emittierenden Zustand durch die Gehäusewand nur in diesem Bereich der Vertiefung lokalisierbar optisch wahrnehmbar ist, im Medizinbereich zur Anzeige des Ladezustands von Batterien, zur Anzeige von Informationen über die abgegebene Lichtintensität, den Einschaltzustand, die Betriebsart oder Fehlermeldungen eines batteriebetriebenen Belichtungsgeräts.

2. Verwendung nach Anspruch 1, wobei die Schichtdicke der Gehäusewand an den Stellen, unterhalb deren sich das lichtemittierende Element befindet, im Vergleich zur üblichen Schichtdicke der Gehäusewand um mindestens 50% geringer ist.

3. Verwendung nach einem der vorstehenden Ansprüche, wobei die Gehäusewand im Bereich der Vertiefung etwas 0,2 bis 0,8 mm stark ist.

4. Verwendung nach einem der vorstehenden Ansprüche, wobei das lichtemittierende Element eine Strahlungsleistung im Bereich von 0,1 bis 30 mW aufweist.

5. Verwendung nach einem der vorstehenden Ansprüche, wobei das mindestens eine lichtemittierende Element in die mindestens eine Vertiefung eingelassen ist.

6. Verwendung nach einem der vorstehenden Ansprüche, wobei der nichttransparente Kunststoff desinfizierbar ist.

7. Verwendung nach einem der vorstehenden Ansprüche, wobei die Oberfläche der Vorrichtung aus einem einheitlichen Material gefertigt ist.

8. Verwendung nach einem der vorstehenden Ansprüche, wobei der nichttransparente Kunststoff gewählt ist aus Polystyrol (PS), Polycarbonat (PC), Acrylnitrilbutadienstyrol (ABS), Polybutylenterephthalat (PBTP), Styrol-Acrylnitril (SAN), Polyamid (PA), Polyoxymethylen (POM), Polyphenylenoxid (PPO), PE, PP, PTFE und Homo- und Copolymere dieser Kunststoffe oder solche Kunststoffe umfasst.

9. Verwendung nach einem der vorstehenden Ansprüche, wobei die Gehäusewand mindestens eine weitere Vertiefung aufweist, in die ein Detektor eingelassen ist, welcher es ermöglicht, das von dem Licht emittierenden Element durch die Gehäusewand hindurch auf einen Gegenstand und das von diesem reflektierte Licht durch die Gehäusewand zu detektieren.

10. Verwendung nach einem der vorstehenden Ansprüche, wobei die optische Wahrnehmung des lichtemittierenden Elements mit dem menschlichen Auge oder mit Strahlungssensoren erfolgt.
